# EUROPEAN PATENT APPLICATION

(11) **EP 4 668 055 A1**
(43) Date of publication of application: **24.12.2025**
(21) Application number: 25183155.8
(22) Date of filing: 16.06.2025
(51) Int. Cl.: G06F 1/20, H01L 23/367, H01L 23/473, H05K 7/20

(54) **MEDIUM FLOW CHANNEL, FLOW CHANNEL PLATE, LIQUID-COOLED SERVER, AND DATA CENTER**

(30) Priority: 18.06.2024 CN 202421394903 U
(71) Applicant: Bitdeer Semiconductor Technology PTE. LTD., 049514 Singapore (SG)
(72) Inventor: YANG, SENFENG, 049514 Singapore (SG); LI, WEIGUO, 049514 Singapore (SG)
(74) Representative: Metida

(57) **Abstract**

Disclosed are a medium flow channel, a flow channel plate, a liquid-cooled server, and a data center. The medium flow channel includes: at least two sub-sections sequentially bent and connected, and connecting sections connecting adjacent sub-sections; wherein a plurality of heat dissipation fins are juxtaposed in each of the sub-sections, each of the heat dissipation fins extending along an extension direction of the sub-section in which the heat dissipation fins are disposed and dividing the sub-section into a plurality of juxtaposed sub-flow channels.

## Description

### TECHNICAL FIELD

The present disclosure relates to the technical field of liquid cooling, and in particular, relates to a medium flow channel, a flow channel plate, a liquid-cooled server, and a data center.

### BACKGROUND

With advancements in technologies, an increasing number of electronic devices employ either air cooling or liquid cooling solutions to address heat dissipation issues. For instance, servers used for high-performance computing, which contain numerous chips, exhibit substantial heat generation during operation. If this heat is not efficiently dissipated in a timely manner, the cumulated heat can adversely affect the performance and operational lifespan of the individual chips, and may even lead to device malfunctions or system crashes.

In conventional liquid cooling schemes, some methods involve adding heat dissipation fins within the flow channels of liquid cooling plates to improve heat dissipation from the chips. However, conventional medium flow channels are often still unable to satisfy the stringent requirements for temperature uniformity across the chips, particularly under high computation workloads. Specifically, the temperature uniformity of chips distributed across a width of the medium flow channel tends to be poor.

### SUMMARY

In view of the above situation, the present disclosure is mainly intended to provide a medium flow channel, a flow channel plate, a liquid-cooled server, and a data center that may enhance the uniformity of flow velocity and temperature of a medium across a width direction of the flow channel, thereby improving temperature consistency (or uniformity) of chips at various locations.

To achieve the above objective, the present disclosure employs the following technical solutions:

In a first aspect, embodiments of the present disclosure provide a medium flow channel, applicable to heat dissipation for chips on a circuit board, the chips on the circuit board being arranged in a plurality of rows, wherein the medium flow channel includes: at least two sub-sections sequentially bent and connected, and connecting sections connecting adjacent sub-sections; wherein each of the sub-sections is in correspondence with at least one row of the chips, and a plurality of heat dissipation fins are juxtaposed in each of the sub-sections, each of the heat dissipation fins extending along an extension direction of the sub-section in which the heat dissipation fins are disposed and dividing the sub-section into a plurality of juxtaposed sub-flow channels; and
each of the connecting sections is provided with a flow guiding structure, the flow guiding structure including a convex curved panel, wherein the convex curved panel protrudes towards an outer wall of a flow channel of the connecting section where the convex curved panel is disposed, and a gap is maintained between the convex curved panel and the heat dissipation fins disposed in the sub-sections upstream and downstream of the convex curved panel, wherein two opposing convex curved surfaces of the convex curved panel are arranged in parallel and respectively form flow guide surfaces.

In some embodiments, the convex curved panel is an arcuate panel, and both of the flow guide surfaces are arcuate surfaces.

In some embodiments, the convex curved panel is a parabolic panel, and both of the flow guide surfaces are parabolic surfaces.

In some embodiments, the two flow guide surfaces of the convex curved panel are arranged in parallel, and the two flow guide surfaces smoothly transition at their ends.

In some embodiments, the flow guiding structure includes a plurality of the convex curved panels juxtaposed and spaced apart.

In some embodiments, the plurality of convex curved panels within a same flow guiding structure are arranged in parallel, and lengths of the plurality of convex curved panels increase from an inner side to an outer side.

In some embodiments, one row of the chips forms a chipset; a same sub-section corresponds to a plurality of rows of chipsets; and a number of sub-flow channels into which the connecting section is divided by the plurality of convex curved panels within a same flow guiding structure is equal to a number of the chipsets.

In some embodiments, in at least one group of communicated connecting sections and two sub-sections, the two sub-sections are juxtaposed, and the flow guiding structure is disposed on each of an upstream side and a downstream side of each of the connecting sections.

In some embodiments, within a same connecting section, a length of the flow guiding structure disposed on the upstream side is less than a length of the flow guiding structure disposed on the downstream side.

In some embodiments, in the flow guiding structure disposed on the upstream side, an angle between a tangent plane at an upstream end of a same convex curved panel and a medium flow direction of the sub-section disposed on the upstream side is less than or equal to 60°, and an angle between a tangent plane at a downstream end of the convex curved panel and a tangent plane at an upstream end of the flow guiding structure on the downstream side is 90° to 180°; an angle between a tangent plane at a downstream end of the flow guiding structure disposed on the downstream side and a medium flow direction of the sub-section disposed on the downstream side is less than or equal to 60°; and a minimum distance between each of the flow guiding structures and an outer wall of the flow channel of the connecting section where the flow guiding structure is disposed is greater than or equal to 1/3 of a width of the flow channel at a location of the flow guiding structure.

In some embodiments, a separating strip is disposed within the medium flow channel, one end of the separating strip being connected to a side wall of the flow channel and the other end of the separating strip being a free end; adjacent two of the sub-sections are separated by the separating strip and connected via the connecting section on a side of the free end; and the two flow guiding structures are disposed on opposite sides of the separating strip.

In a second aspect, embodiments of the present disclosure provide a flow channel plate, applicable to dissipating heat from chips on a circuit board, wherein the medium flow channel as described above is disposed within the flow channel plate.

In a third aspect, embodiments of the present disclosure provide a liquid-cooled server. The liquid-cooled server includes: a circuit board and the flow channel plate as described above; wherein a plurality of chips being disposed on the circuit board, wherein the plurality of chips are arranged on the circuit board in a plurality of rows of chipsets, each row of the chipsets including a plurality of chips arranged along an extension direction X of sub-sections; and the circuit board is mounted on the flow channel plate, and each of the sub-sections corresponds to at least one row of the chipsets.

In some embodiments, each of the chipsets includes at least forty of the chips, and the chips in a same chipset are connected in series; and at least eight rows of the chipsets arranged on the circuit board.

In a fourth aspect, embodiments of the present disclosure provide a data center. The data center includes the liquid-cooled server as described above.

In the medium flow channel according to the present disclosure, a convex curved panel is arranged at a connection point between two sub-sections, i.e., in a connecting section. The two flow guide surfaces of the convex curved panel are both convex curved surfaces, and each of the flow guide surfaces is a smooth curved surface. Therefore, at the connecting section, the medium flow is capable of moving smoothly along the guide surfaces. This minimizes, as much as possible, the impact on heat transfer effectiveness caused by bubble formation in the medium flow at the bends, especially the heat transfer effectiveness of the medium flow in the edge portions near the flow channel sidewalls, such that the heat transfer effectiveness at various points across the width direction of the flow channel is made as consistent as possible. Furthermore, by incorporating the flow guiding structure of the convex curved panel, it is possible to make the flow velocity at various points across the width direction of the flow channel to be as consistent as possible, which further contributes to the consistency of heat transfer effectiveness at various points across the width direction of the flow channel. When the medium flow channel is used for dissipating heat from chips, each of the sub-sections corresponds to at least one row of chips, thereby enabling the heat dissipation effect for each chip located along the width direction of the flow channel to be as uniform as possible. This improves the temperature consistency of the chips across the width direction, thereby enhancing the operational performance of the entire liquid-cooled server and extending the service life thereof.

Other beneficial effects of the present disclosure are described in retail with reference to specific technical features and technical solutions in the specific embodiments. A person skilled in the art may understand the beneficial effects achieved by these technical features and technical solutions through description of these technical features and technical solutions.

### BRIEF DESCRIPTION OF THE DRAWINGS

Some embodiments of the present disclosure are described with reference to accompanying drawings hereinafter.
FIG. 1 is a schematic structural view of a medium flow channel according to some embodiments of the present disclosure;
FIG. 2 is a schematic partial front view of a medium flow channel according to some embodiments of the present disclosure;
FIG. 3 is a schematic structural view of a flow guiding structure in a medium flow channel according to some embodiments of the present disclosure;
FIG. 4 is a schematic partial front view of a medium flow channel according to some embodiments of the present disclosure;
FIG. 5 is a schematic partial front view of a medium flow channel according to some embodiments of the present disclosure; and
FIG. 6 is a schematic structural view of a flow channel plate according to some embodiments of the present disclosure.

Reference numerals and denotations thereof: 10-medium flow channel; 11-sub-section; 12-connecting section; 121-flow channel inner wall; 122-flow channel outer wall; 13-heat dissipation fin; 131-sub-segment; 14-flow guiding structure; 141-convex curved panel; 1411-flow guide surface; 1412-end face; 142-connecting surface; 15-separating strip; 20-base shell; 21-medium inlet; 22-medium outlet; and 30-cover plate.

### DETAILED DESCRIPTION

The present disclosure is described with reference to some exemplary embodiments. However, the present disclosure is not limited to these exemplary embodiments. In the detailed description of the present disclosure, specific details are set forth. To avoid unnecessarily obscuring the substance of the present disclosure, well-known methods, procedures, processes, and components have not been described in detail.

Furthermore, it should be understood by persons of ordinary skill in the art that the drawings provided herein are for illustrative purposes only and are not necessarily drawn to scale.

Unless the context clearly requires otherwise, throughout this specification and the claims, the words "comprise," "contain," and the like are to be construed in an inclusive sense, as opposed to an exclusive or exhaustive sense, that is, in the sense of "including, but not limited to."

It should be noted that terms such as "first," "second," and the like are merely used for illustration purpose during the description of the present disclosure, and shall not be understood as indicating or implying relative importance. In addition, in the description of the present disclosure, the term "multiple," "more," or "a plurality of" refers to at least two unless otherwise specified.

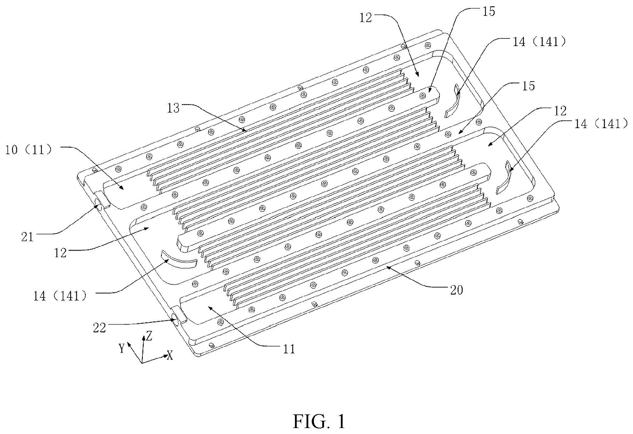

For convenience of description, a Cartesian coordinate system is established based on an extension direction X, a width direction Y, and a depth direction Z of a sub-section of a medium flow channel, as illustrated in FIG. 1. It should be noted that the establishment of this coordinate system is solely for convenience of description and does not impose specific limitations on the state of use of the medium flow channel. During use or placement, the respective directions may be defined according to the actual orientation or operating state of a flow channel plate.

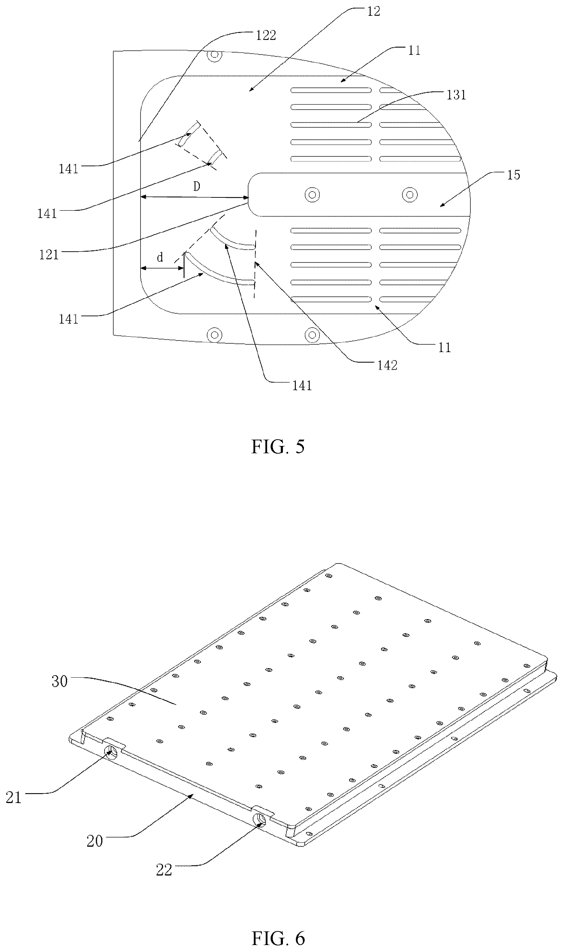

The present disclosure provides a flow channel plate. The flow channel plate may be used for cooling components of electronic devices that produce heat during operation; specifically, for dissipating heat from chips on a circuit board, such as dissipating heat from chips of a liquid-cooled server, wherein the chips on the circuit board are arranged in a plurality of rows. As illustrated in FIG. 6, a medium flow channel 10 is arranged within the flow channel plate. Referring to FIG. 1 to FIG. 5, the medium flow channel 10 includes at least two sub-sections 11, which are sequentially bent and connected, and connecting sections 12 that connect adjacent sub-sections 11. That is, a plurality of sub-sections 11 are connected together via a plurality of connecting sections 12, thereby forming a communicated medium flow channel 10 composed of these sub-sections 11 and connecting sections 12. This medium flow channel 10 is configured with bends (or turns) to change the direction of the medium flow. The medium flow channel 10 includes flow channel sidewalls. At the bends, in a connecting section 12, the flow channel sidewall disposed on the radially inner side is a flow channel inner wall 121, and the flow channel sidewall disposed on a radially outer side is a flow channel outer wall 122. Within each of the sub-sections 11, a plurality of heat dissipation fins 13 are juxtaposed. Each of the heat dissipation fins 13 extends along the extension direction X of the sub-section 11 where the heat dissipation fin 13 is disposed. The plurality of heat dissipation fins 13 divide the sub-section 11 into a plurality of sub-flow channels that are juxtaposed. The connecting section 12 is provided with a flow guiding structure 14. The flow guiding structure 14 includes a convex curved panel 141. The convex curved panel 141 protrudes towards the flow channel outer wall of the connecting section 12 where the convex curved panel 14 is disposed. Furthermore, a gap is maintained between the convex curved panel 141 and the heat dissipation fins 13 in the sub-sections 11 disposed upstream and downstream thereof. Two opposite convex curved surfaces of the convex curved panel 141 are arranged in parallel, respectively forming flow guide surfaces 1411. Both of the flow guide surfaces 1411 are smooth curved surfaces and protrude towards the radially outer side at the bend where the flow guide surfaces are disposed. When the medium flow channel is used to dissipate heat from chips, each of the sub-sections 11 may correspond to at least one row of chips (as detailed hereinafter).

In the medium flow channel according to the present disclosure, a convex curved panel 141 is arranged at a connection point between two sub-sections 11, i.e., in a connecting section 12. The two flow guide surfaces 1411 of the convex curved panel 141 are both convex curved surfaces, and each of the flow guide surfaces is a smooth curved surface. Therefore, at the connecting section 12, the medium flow is capable of moving smoothly along the flow guide surfaces 1411. This minimizes, as much as possible, the impact on heat transfer effectiveness caused by bubble formation in the medium flow at the bends, especially the heat transfer effectiveness of the medium flow in the edge portions near the flow channel sidewalls, such that the heat transfer effectiveness at various points across the width direction Y of the flow channel is made as consistent as possible. Furthermore, by incorporating the flow guiding structure 14 of the convex curved panel 141, it is possible to make the flow velocity at various points across the width direction Y of the flow channel to be as consistent as possible, which further contributes to the consistency of heat transfer effectiveness at various points across the width direction Y of the flow channel. Simultaneously, by maintaining a gap between the flow guiding structure 14 and the upstream and downstream heat dissipation fins 13 such that they are not directly connected, it is also possible to avoid turbulence at the bends that may affect the heat transfer performance and flow velocity of the medium flow while enabling smooth medium flow. This, in turn, better enhances the consistency of flow velocity and temperature of the medium flow across the width direction at the entire bend. When the medium flow channel is used for dissipating heat from chips, the heat dissipation effect is enabled for each chip located along the width direction Y of the flow channel to be as uniform as possible. This improves the temperature consistency of the chips across the width direction Y, thereby enhancing the operational performance of the entire liquid-cooled server and extending the service life thereof.

Specifically, the heat dissipation fins 13 are configured as strip-like plate structures. Within each of the sub-sections 11, two, three, or more heat dissipation fins 13 may be arranged. As illustrated in FIG. 1, five heat dissipation fins are arranged within each of the sub-sections 11. A space between two adjacent heat dissipation fins 13 in the width direction Y, a space between the innermost heat dissipation fin 13 and the flow channel inner wall of the sub-section where the innermost heat dissipation fin is disposed, and a space between the outermost heat dissipation fin 13 and the flow channel outer wall of the sub-section 11 where the outermost heat dissipation fin is disposed cooperatively form a sub-flow channel. Thus, the plurality of heat dissipation fins 13 juxtaposed within a same sub-section 11 divide the sub-section 11 into a plurality of sub-flow channels. In this way, the plurality of heat dissipation fins 13 exert a compressive effect on the medium flow within the sub-section 11, thereby increasing the flow velocity of the medium flow. This also increases the heat exchange area, thereby improving the heat exchange efficiency of the medium flow channel, while simultaneously ensuring that the flow velocity of the medium flow at various points across the width direction Y is as consistent as possible.

The plurality of sub-sections 11 may be arranged parallel to each other, i.e., juxtaposed along their respective width directions Y. Their respective flow cross-sectional areas are equal. For example, their width dimensions in the width direction Y and their depth dimensions in the depth direction Z are all equal. Furthermore, the flow cross-sectional areas of each connecting section 12 are also equal and are substantially equal to the flow cross-sectional areas of each sub-section 11. The flow cross-sectional area within each sub-section 11 excluding the heat dissipation fins 13, and the flow cross-sectional area within each connecting section 12 excluding the flow guiding structure 14 are equal.

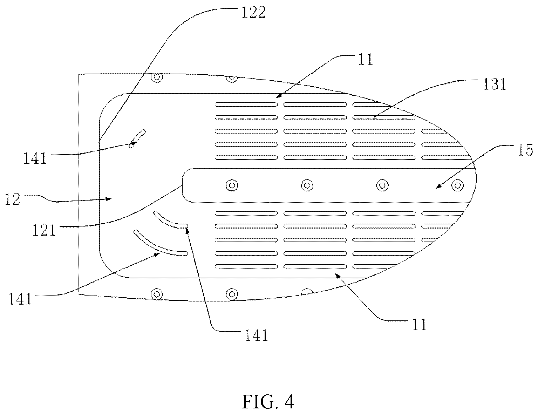

Each of the heat dissipation fins 13 within the sub-section 11 may be a single continuous strip arranged along the entire region of the sub-section 11 in its extension direction X, as illustrated in FIG. 1. Alternatively, the heat dissipation fin 13 may also be composed of a plurality of sub-segments 131 arranged discontinuously (or "intermittently"), as illustrated in FIG. 4 and FIG. 5. Within the same sub-section 11, a plurality of sub-segments 131 of different heat dissipation fins 13 form a plurality of heat dissipation groups. A plurality of such heat dissipation groups are spaced apart along the extension direction X. Each of the heat dissipation groups includes one sub-segment 131 from each of the different heat dissipation fins. Through these spaced-apart sub-segments, turbulence within the sub-section 11 is further avoided, thereby enhancing the heat dissipation performance and anti-noise capability of the entire medium flow channel.

The two flow guide surfaces 1411 of the same convex curved panel 141 are mutually parallel, that is, the convex curved panel 141 has a structure with a uniform wall thickness. This increases the consistency of the flow guiding effect on the medium flow at various points across the width direction of the connecting section 12.

Furthermore, the two flow guide surfaces 1411 of the same convex curved panel 141 have a smooth transition at their ends. That is, the convex curved panel 141 includes an end face 1412 that is connected to the two flow guide surfaces 1411, and the end face 1412 is a smooth convex curved surface. In other words, the two flow guide surfaces 1411 and the end face 1412 are smoothly connected. The ends of the two flow guide surfaces 1411 do not form sharp corners (a non-sharp-cornered structure) at the same side, nor are the two flow guide surfaces connected by a plane perpendicular thereto (i.e., a tangent plane to these two flow guide surfaces). By using the convex curved panel 141 according to the embodiments, the flow guiding effect on the medium flow at the connecting section 12 is further enhanced.

Specifically, the convex curved panel 141 may be various types of curved panels, such as an arc-shaped panel, a parabolic panel, or a free-form curved panel. When the convex curved panel 141 is an arc-shaped panel, both of the flow guide surfaces are arc-shaped surfaces; when the convex curved panel 141 is a parabolic panel, both of the flow guide surfaces are parabolic surfaces; and when the convex curved panel 141 is a free-form curved panel, both of the flow guide surfaces are free-form curved surfaces. In some embodiments, the convex curved panel 141 is an arc-shaped panel, which may be a circular arc panel or an elliptical arc panel. Further preferably, the convex curved panel 141 is a circular arc panel, which may substantially prevent direct impingement of the medium flow against the inner wall of the medium flow channel, such that the flow guiding effect of the convex curved panel 141 on the medium flow is enhanced. This flow guiding effect is particularly pronounced, especially when compared to providing a wedge-shaped structure at the bent connection.

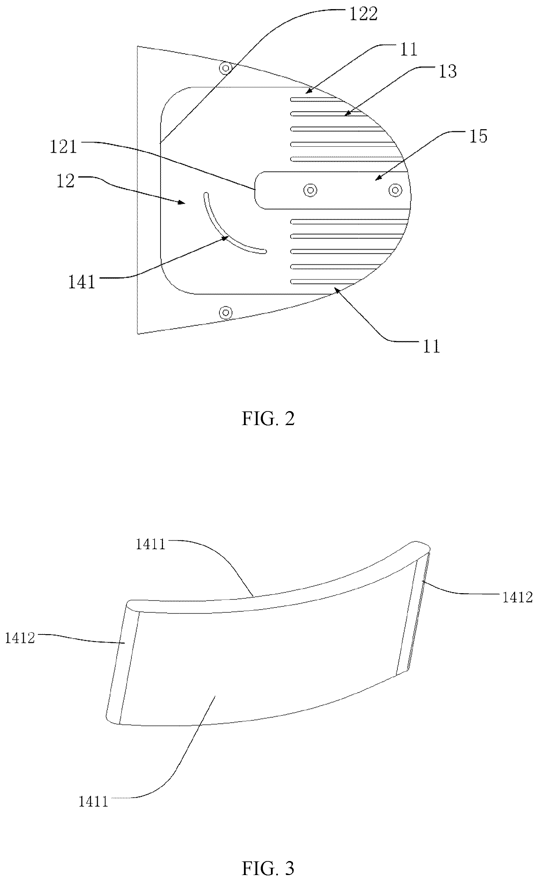

The flow guiding structure 14 may include only one convex curved panel 141, as illustrated in FIG. 2. This convex curved panel 141 may be substantially disposed at a middle location in the width direction of the medium flow channel at that point, i.e., distances from the two flow guide surfaces 1411 to the respective flow channel sidewalls on the same side are substantially equal. In some embodiments, the flow guiding structure 14 includes a plurality of convex curved panels 141 juxtaposed and spaced apart from each other; that is, a plurality of convex curved panels 141 are juxtaposed in the width direction of the medium flow channel. Specifically, the same flow guiding structure 14 may be provided with two convex curved panels 141, three convex curved panels 141, or more. These convex curved panels 141 divide the connecting section 12 into a plurality of sub-flow channels. Referring to FIG. 4, one flow guiding structure 14 in the same connecting section 12 is illustrated. This flow guiding structure 14 includes two convex curved panels 141, which divide the connecting section 12 into three sub-flow channels. With the plurality of convex curved panels 141, it is possible to further increase the consistency of the flow velocity and temperature of the medium flow at various points along the width direction at the connecting section 12, thereby enhancing the heat dissipation performance of the entire flow channel plate. Furthermore, the plurality of convex curved panels 141 are uniformly distributed in the width direction of the connecting section 12, such that the plurality of sub-flow channels are uniform.

In embodiments where the flow guiding structure 14 includes a plurality of convex curved panels 141, the plurality of convex curved panels 141 are arranged in parallel, and their lengths increase from an inner side towards an outer side. That is, among the plurality of convex curved panels 141, the convex curved panel 141 closest to the flow channel inner wall 121 has a smallest length, and the convex curved panel 141 closest to the flow channel outer wall 122 has a largest length. More preferably, the surface formed by connecting the corresponding ends of the plurality of convex curved panels 141 is a planar surface, and a connecting surface 142 as indicated by the dashed lines in FIG. 5 is a planar surface. By adopting this structure, it is possible to extend the guiding length provided by the flow guiding structure 14 for the medium flow in the outer portions of the connecting section 12. This further reduces bubble formation caused by the impingement of this portion of the medium flow against the flow channel outer wall 122, thereby improving the heat transfer performance of the entire medium flow. The length of the convex curved panel 141 refers to the dimension of the convex curved panel 141 along a direction of curvature thereof, and also refers to the length when the convex curved panel 141 is unfolded into a flat plate.

To improve the heat dissipation efficiency of the flow channel plate, during installation of the flow channel plate and a circuit board (not illustrated in the drawings), the same sub-section may correspond to a plurality of rows of chipsets (as detailed hereinafter). In the embodiments, preferably, the number of sub-flow channels into which the connecting section 12 is divided by the plurality of convex curved panels 141 within the same flow guiding structure 14 is equal to the number of chipsets. For example, in a case where the same sub-section 11 corresponds to two rows of chipsets, the same flow guiding structure 14 may be provided with one convex curved panel 141 to divide the connecting section 12 into two sub-flow channels. Still for example, in a case where the same sub-section 11 corresponds to three rows of chipsets, the same flow guiding structure 14 may be provided with two convex curved panels 141 to divide the connecting section 12 into three sub-flow channels. By forming sub-flow channels in the connecting section 12 in a quantity that is equal to the number of chipsets corresponding to the sub-section 11, the consistency of the flow velocity and temperature of the medium flow in the medium flow channel corresponding to each of the chipsets is enhanced, thereby enhancing the consistency of the heat dissipation effect for each chipset. Within the same sub-section 11, the number of sub-flow channels formed by the plurality of heat dissipation fins 13 is preferably greater than the number of chipsets corresponding to the sub-section. For example, in a case where the same sub-section 11 corresponds to three rows of chipsets, five heat dissipation fins 13 may be arranged to divide the sub-section 11 into six sub-flow channels. In this way, while enhancing the heat dissipation efficiency for the circuit board, the compressive effect of the heat dissipation fins 13 on the medium flow is increased, thereby increasing the flow velocity of the medium flow, and also the heat exchange area is increased, thereby better enhancing the heat dissipation efficiency.

Within the same connecting section 12, only one flow guiding structure 14 may be arranged. This flow guiding structure may be disposed on the upstream side, the downstream side, or at an intermediate location within the connecting section 12. In some embodiments, a flow guiding structure 14 according to any of the embodiments described above is arranged on each of the upstream side and the downstream side of the same connecting section 12. Preferably, a gap is maintained between the flow guiding structures 14 at the two locations (as detailed hereinafter). As illustrated in FIG. 5, in at least one group of communicated connecting sections 12 and two sub-sections 11, where the two sub-sections 11 are juxtaposed, a flow guiding structure 14 is arranged on each of the upstream side and the downstream side of the connecting section 12, and a gap is maintained between the flow guiding structures 14 at these two locations, i.e., the two flow guiding structures 14 are not adjacent. In some embodiments, the flow guiding structures at both locations both include an equal number of convex curved panels 141. The embodiments are particularly suitable for configurations where a plurality of sub-sections 11 are juxtaposed. According to the embodiments, the flow guiding effect is enhanced for the upstream medium flow entering the connecting section 12 from the upstream sub-section 11, the flow guiding effect is enhanced for the medium flow entering the downstream sub-section 11 from the connecting section 12, and the impingement of the medium flow against the flow channel inner wall 121 and the flow channel outer wall 122 is reduced, such that the heat dissipation effect of the entire flow channel plate is improved.

In embodiments where flow guiding structures 14 are arranged simultaneously on both the upstream and downstream sides within the same connecting section 12, preferably, the length of the flow guiding structure 14 disposed on the upstream side is less than the length of the flow guiding structure on the downstream side. That is, the length of the convex curved panels 141 on the upstream side is less than the length of the convex curved panels 141 on the downstream side. By arranging a flow guiding structure 14 of a greater length, where possible, on the downstream side, a guide path for the medium flow is extended, thereby enabling the medium flow to enter the sub-section 11 on the downstream side more smoothly. This enhances the overall guiding effect on the medium flow and increases the consistency of the flow velocity and temperature of the medium flow at various points across the width direction at the same location.

In the flow guiding structure on the upstream side, an angle between a tangent plane at an upstream end of a same convex curved panel 141 and a medium flow direction of the sub-section 11 on the upstream side is less than or equal to 60°, and an angle between a tangent plane at a downstream end of the convex curved panel 11 and a tangent plane at an upstream end of the flow guiding structure 14 on the downstream side is 90° to 180°; an angle between a tangent plane at a downstream end of the flow guiding structure on the downstream side and a medium flow direction of the sub-section 11 disposed on the downstream side is less than or equal to 60°. Referring to FIG. 5, the flow guiding structure 14 on the upstream side in FIG. 5 is the upstream flow guiding structure 14, and each of the convex curved panels 141 is referred to as an upstream curved panel. The flow guiding structure 14 on a lower side in FIG. 5 is a downstream flow guiding structure 14, and each of the convex curved panels 141 is referred to as a downstream curved panel. The angle between the tangent plane at the upstream end of an upstream curved panel and the medium flow direction of the medium flow in the upstream sub-section 11 is denoted as a first angle A. The angle between the tangent plane at the downstream end of the upstream curved panel and the tangent plane at the upstream end of a downstream curved panel is denoted as a second angle B. The angle between the tangent plane at the downstream end of a downstream curved panel and the medium flow direction of the medium flow in the downstream sub-section 11 is denoted as a third angle C. Then, the first angle A and the third angle C are less than or equal to 60 degrees, for example, 60°, 50°, 40°, 30°, 20°, 10°, 5°, or 1°, or even 0° (i.e., parallel), which means that the tangent plane at the upstream end of the upstream curved panel is parallel to the medium flow direction of the medium flow in the upstream sub-section 11, and the tangent plane at the downstream end of the downstream curved panel is parallel to the medium flow direction of the medium flow in the downstream sub-section 11. The second angle B is between 90° and 180°, for example, 90°, 120°, 135°, 150°, or 180°. It should be noted that the first angle A and the third angle C may be equal or unequal. In embodiments where each of the flow guiding structures includes a plurality of convex curved panels, within the same connecting section 12, all upstream curved panels are arranged in parallel, and all downstream curved panels are arranged in parallel. In some embodiments, the tangent plane at the upstream end of an upstream curved panel is parallel to the flow direction of the medium in the upstream sub-section 11, and the tangent plane at the downstream end of a downstream curved panel is parallel to the flow direction of the medium in the downstream sub-section 11. This configuration enhances the flow guiding effect at the connecting section 12 and improves the flow velocity and heat dissipation performance of the entire medium flow.

Regardless of which of the above-described embodiments is adopted for the flow guiding structure 14, in an exemplary embodiment, a minimum distance between each of the flow guiding structures 14 and the flow channel outer wall 122 of the connecting section 12 where the flow guiding structure is disposed is greater than or equal to 1/3 of a width of the flow channel at that point. As illustrated in FIG. 5, in the downstream flow guiding structure 14, a minimum distance d between the upstream end of the outermost downstream curved panel and the flow channel outer wall of the connecting section 12 at that point is greater than or equal to 1/3 of a width D of the flow channel at that point. For example, d may be equal to 1/3 or 1/2 of D.

A separating strip 15 is arranged within the medium flow channel 10. One end of the separating strip 15 is connected to a flow channel sidewall, and the other end is a free end. As illustrated in FIG. 1, two adjacent sub-sections 11 are separated by the separating strip 15 and are connected via a connecting section 12 on the side of the free end. The two flow guiding structures 14 are disposed on opposite sides of the separating strip 15. Specifically, the connecting section 12 includes a first connecting segment, a second connecting segment, and a third connecting segment, which are sequentially connected. The first connecting segment and the second connecting segment are respectively connected to the upstream sub-section 11 and the downstream sub-section 11. The first connecting segment may be formed by the upstream sub-section 11 extending along a medium flow direction (i.e., extension direction X) thereof. The third connecting segment is formed by the downstream sub-section 11 extending in the reverse direction of a medium flow direction thereof. The second connecting segment is disposed in the extension direction of the separating strip 15. The entire medium flow channel forms an intervening space (gap space) on the side of the free end of the separating strip 15, and the two flow guiding structures 14 are separated by the intervening space. With the two flow guiding structures that are spaced apart, the flow guiding effect within the connecting section 12 is enhanced while simultaneously avoiding turbulence in the medium flow between the two flow guiding structures, thereby further improving the heat dissipation performance and anti-noise capability of the flow channel plate.

Referring to FIG. 6, the flow channel plate includes a base shell 20 and a cover plate 30. The base shell 20 and the cover plate 30 are assembled and sealed together, and form therein the medium flow channel 10 according to any of the embodiments described above. Specifically, the flow channel plate may be a cuboid-shaped (or rectangular parallelepiped-shaped) plate structure. A plurality of sub-sections 11 extend along the length direction of the flow channel plate. The width direction of the sub-sections 11 corresponds to the width direction of the flow channel plate, and the depth direction of the sub-sections 11 corresponds to the thickness direction of the flow channel plate. Specifically, one surface of the base shell 20 is recessed to form a plurality of recessed regions, and the heat dissipation fins 13 are disposed within these recessed regions. The cover plate 30 covers and seals the openings of the recessed regions. The recessed regions, together with the corresponding areas on the cover plate 30, form the medium flow channel. A medium inlet 21 and a medium outlet 22 are arranged in an end face of the base shell 20 (i.e., a face in the extension direction X). The medium inlet 21 and the medium outlet 22 are respectively in communication with the two ends of the medium flow channel. The medium inlet 21 and the medium outlet 22 may be disposed in the same end face or on different end faces.

In some embodiments, pipe connectors are respectively connected to the medium inlet 21 and the medium outlet 22 to facilitate the connection of the liquid cooling plate with an external coolant.

Some embodiments of the present disclosure further provide a liquid-cooled server. The liquid-cooled server includes the flow channel plate according to any of the embodiments described above. The liquid-cooled server further includes a circuit board, wherein a plurality of chips are arranged on the circuit board. After the circuit board and the flow channel plate are installed, the chips are disposed in a region, where the medium flow channel is disposed, of the liquid cooling plate, so as to improve the heat dissipation efficiency for the chips.

The plurality of chips on the circuit board are arranged into a plurality of rows of chipsets. Each row of chipsets includes a plurality of chips arranged along the extension direction X of the sub-section 11. When the circuit board is installed on the flow channel plate, each of the sub-sections corresponds to at least one row of chipsets. For instance, one sub-section 11 may correspond to one row of chipsets, or one sub-section 11 may correspond to a plurality of rows of chipsets, for example, two rows, three rows, or more rows of chipsets.

In some embodiments, each of the chipsets includes at least forty chips, and the chips within the same chipset are connected in series. The circuit board has at least eight rows of chipsets arranged thereon. For example, the circuit board may have eight, ten, twelve, fourteen, fifteen, or sixteen rows of chipsets arranged thereon. One row of chipsets includes, for example, forty, forty-five, fifty, fifty-five, or sixty chips. The numbers of chips in individual chipsets may be equal or unequal.

Some embodiments of the present disclosure further provide a data center. The data center includes a plurality of the liquid-cooled servers as described above.

A person skilled in the art would understand that the above technical solutions may be freely combined and superimposed as long as no conflicts exist.

It should be understood that the above embodiments are only exemplary, and construe no limitations. Under the circumstance of not departing from the basic principles of the present disclosure, various obvious or equivalent modifications or substitutions that persons skilled in the art may derive to the above-described details are all included within the scope of the claims of the present disclosure.

## Claims

1. A medium flow channel, applicable to heat dissipation for chips on a circuit board, the chips on the circuit board being arranged in a plurality of rows, wherein the medium flow channel comprises: at least two sub-sections sequentially bent and connected, and connecting sections connecting adjacent sub-sections; wherein each of the sub-sections is in correspondence with at least one row of the chips, and a plurality of heat dissipation fins are juxtaposed in each of the sub-sections, each of the heat dissipation fins extending along an extension direction of the sub-section in which the heat dissipation fins are disposed and dividing the sub-section into a plurality of juxtaposed sub-flow channels; and
each of the connecting sections is provided with a flow guiding structure, the flow guiding structure comprising a convex curved panel, wherein the convex curved panel protrudes towards an outer wall of a flow channel of the connecting section where the convex curved panel is disposed, and a gap is maintained between the convex curved panel and the heat dissipation fins disposed in the sub-sections upstream and downstream of the convex curved panel, wherein two opposing convex curved surfaces of the convex curved panel are arranged in parallel and respectively form flow guide surfaces.

2. The medium flow channel according to claim 1, wherein the convex curved panel is an arcuate panel, and both of the flow guide surfaces are arcuate surfaces.

3. The medium flow channel according to claim 1, wherein the convex curved panel is a parabolic panel, and both of the flow guide surfaces are parabolic surfaces.

4. The medium flow channel according to claim 1, wherein the two flow guide surfaces of the convex curved panel are arranged in parallel, and the two flow guide surfaces smoothly transition at their ends.

5. The medium flow channel according to claim 1, wherein the flow guiding structure comprises a plurality of the convex curved panels juxtaposed and spaced apart.

6. The medium flow channel according to claim 5, wherein the plurality of convex curved panels within a same flow guiding structure are arranged in parallel, and lengths of the plurality of convex curved panels increase from an inner side to an outer side.

7. The medium flow channel according to claim 5, wherein one row of the chips forms a chipset; a same sub-section corresponds to a plurality of rows of chipsets; and a number of sub-flow channels into which the connecting section is divided by the plurality of convex curved panels within a same flow guiding structure is equal to a number of the chipsets.

8. The medium flow channel according to any one of claims 1 to 7, wherein in at least one group of communicated connecting sections and two sub-sections, the two sub-sections are juxtaposed, and the flow guiding structure is disposed on each of an upstream side and a downstream side of each of the connecting sections.

9. The medium flow channel according to claim 8, wherein within a same connecting section, a length of the flow guiding structure disposed on the upstream side is less than a length of the flow guiding structure disposed on the downstream side.

10. The medium flow channel according to claim 8, wherein in the flow guiding structure disposed on the upstream side, an angle between a tangent plane at an upstream end of a same convex curved panel and a medium flow direction of the sub-section disposed on the upstream side is less than or equal to 60°, and an angle between a tangent plane at a downstream end of the convex curved panel and a tangent plane at an upstream end of the flow guiding structure on the downstream side is 90° to 180°; an angle between a tangent plane at a downstream end of the flow guiding structure disposed on the downstream side and a medium flow direction of the sub-section disposed on the downstream side is less than or equal to 60°; and a minimum distance between each of the flow guiding structures and an outer wall of the flow channel of the connecting section where the flow guiding structure is disposed is greater than or equal to 1/3 of a width of the flow channel at a location of the flow guiding structure.

11. The medium flow channel according to claim 8, wherein a separating strip is disposed within the medium flow channel, one end of the separating strip being connected to a side wall of the flow channel and the other end of the separating strip being a free end; adjacent two of the sub-sections are separated by the separating strip and connected via the connecting section on a side of the free end; and the two flow guiding structures are disposed on opposite sides of the separating strip.

12. A flow channel plate, applicable to dissipating heat from chips on a circuit board, wherein the medium flow channel according to any one of claims 1 to 11 is disposed within the flow channel plate.

13. A liquid-cooled server, comprising: a circuit board and the flow channel plate according to claim 12; wherein a plurality of chips being disposed on the circuit board, wherein the plurality of chips are arranged on the circuit board in a plurality of rows of chipsets, each row of the chipsets comprising a plurality of chips arranged along an extension direction X of sub-sections; and the circuit board is mounted on the flow channel plate, and each of the sub-sections corresponds to at least one row of the chipsets.

14. The liquid-cooled server according to claim 13, wherein each of the chipsets comprises at least forty of the chips, and the chips in a same chipset are connected in series; and at least eight rows of the chipsets arranged on the circuit board.

15. A data center, comprising: the liquid-cooled server according to claim 13 or claim 14.
